(19) Europäisches Patentamt / European Patent Office / Office européen des brevets

(11) **EP 2 717 323 A1**

(12) **EUROPEAN PATENT APPLICATION**
published in accordance with Art. 153(4) EPC

(43) Date of publication:
**09.04.2014 Bulletin 2014/15**

(51) Int Cl.:
**H01L 31/04** (2014.01)

(21) Application number: **12790092.6**

(22) Date of filing: **08.05.2012**

(86) International application number:
**PCT/JP2012/003008**

(87) International publication number:
**WO 2012/160764 (29.11.2012 Gazette 2012/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.05.2011 JP 2011116047**

(71) Applicant: **JX Nippon Oil & Energy Corporation**
**Chiyoda-ku**
**Tokyo 100-8162 (JP)**

(72) Inventors:
• **GOTO, Masanao**
  **Tokyo 100-8162 (JP)**
• **HAYASHI, Shinya**
  **Tokyo 100-8162 (JP)**
• **NAKAYAMA, Keisuke**
  **Tokyo 100-8162 (JP)**

(74) Representative: **Algemeen Octrooi- en Merkenbureau B.V.**
**P.O. Box 645**
**5600 AP Eindhoven (NL)**

(54) **PHOTOELECTRIC CONVERSION ELEMENT**

(57)    A photoelectric conversion element 10 includes a photoelectric conversion layer 20, an anti-reflection film 32, a light scattering layer 36, and a transparent thin layer 50. The anti-reflection film 32 is provided on a light-receiving surface side of the photoelectric conversion layer 20. The light scattering layer 36 is made of a plurality of metal nano-particles that are two-dimensionally arranged to be opposite to the light-receiving surface of the photoelectric conversion layer 20. The transparent thin layer 50 is provided between the photoelectric conversion layer 20 and the light scattering layer 36. A thickness $d_{low}$ of the transparent thin layer 50 is represented by the following equation.

[Equation 1]

$$0 < d_{low} < \lambda_0 \left(\frac{n_{low}}{n_{abs}}\right)^2 \frac{1}{n_{abs}^2 - n_{low}^2}$$

wherein $\lambda_0$ represents an arbitrary wavelength of light in vacuum, the light being able to be absorbed by the photoelectric conversion layer 20; $n_{abs}$ represents a refractive index of the photoelectric conversion layer 20 at the wavelength; and $n_{low}$ represents a refractive index of the transparent thin layer 50 at the wavelength.

EP 2 717 323 A1

FIG.1A

FIG.1B

## Description

TECHNICAL FIELD

The present invention relates to a photoelectric conversion element configured to convert light energy into electric energy by photoelectric conversion.

BACKGROUND ART

In photoelectric conversion elements, such as a solar cell, it is desired that the thickness of a photoelectric conversion layer is made further small in order to achieve resource saving and cost reduction. If the thickness thereof is simply made small, an amount of the light absorbed in the photoelectric conversion layer is decreased, and hence a technique of increasing an amount of the light absorbed in a photoelectric conversion layer is essential.

As such a technique, a technique is known, in which an optical path length in a solar cell is made long by providing, as a light scattering layer, metal nano-structures (metal nano-particles array, metal nano-holes array, metal grating structures, etc.) on the top surface and/or the rear surface of a photoelectric conversion layer to obliquely scatter the incident light, thereby allowing a current to be increased.

[Related Art Documents]

[Patent Documents]

[Patent Document 1] Japanese Patent Application Publication No. 2000-294818
[Patent Document 2] Japanese Patent Application Publication No. 2001-127313
[Patent Document 3] Japanese Patent Application Publication No. 2009-533875

[Non-Patent Document]

[Non-Patent Document 1] Beck et al., Journal of Applied Physics, 105, 114310 (2009).
[Non-Patent Document 2] Mokkapati et al., Applied Physics Letters, 95, 053115 (2009).

DISCLOSURE OF THE INVENTION

Problem to be Solved by the Invention

If the photoelectric conversion layer (active layer) of a solar cell and the metal for scattering the reflected light are in direct contact with each other, the performance of the solar cell, in particular, the open circuit voltage is decreased, and hence it is needed to insert a dielectric body or a semiconductor between the photoelectric conversion layer and the light scattering layer. However, there is a problem in a conventional technique, in which, if a layer of dielectrics or semiconductors is inserted between the photoelectric conversion layer and the metal nano-structures, an effect of the metal nano-structures is decreased. It is unknown what type of a insertion layer increases a current by photoelectric conversion, while suppressing a decrease in the performance of a solar cell and finally improves the performance thereof.

The present invention has been made in view of such a problem, and a purpose of the invention is provide a technique in which, in a structure in which a light scattering layer is provided on at least one surface of a photoelectric conversion layer, an effect of increasing current can be obtained, while suppressing a decrease in the performance of a solar cell.

Means for Solving the Problem

An aspect of the present invention is a photoelectric conversion element. The photoelectric conversion element comprises: a photoelectric conversion layer; a transparent thin layer that is laminated on one major surface of the photoelectric conversion layer and that has a refractive index different from that of the photoelectric conversion layer; and a light scattering layer laminated on a major surface of the transparent thin layer, the major surface being on the side opposite to the photoelectric conversion layer, in which a thickness $d_{low}$ of the transparent thin layer is represented by the following equation.

[Equation 1]

$$0 < d_{low} < \lambda_0 \left(\frac{n_{low}}{n_{abs}}\right)^2 \frac{1}{n_{abs}^2 - n_{low}^2}$$

wherein $\lambda_0$ represents an arbitrary wavelength of light in vacuum, the light being able to be absorbed by the photoelectric conversion layer; nabs represents a refractive index of the photoelectric conversion layer at the wavelength; and $n_{low}$ represents a refractive index of the transparent thin layer at the wavelength.

According to the photoelectric conversion element of this aspect, incident light that has not been absorbed by the photoelectric conversion element is scattered and reflected by a plurality of metal nano-particles provided on a major surface side of the photoelectric conversion element, the major surface being on the side opposite to a light receiving surface, and hence an optical path length for incident light in the photoelectric conversion layer is increased, thereby allowing the incident light to be efficiently absorbed. Further, by interposing the aforementioned transparent thin layer having a thickness of $d_{low}$ between the photoelectric conversion layer and the light scattering layer, an effect of increasing current in the photoelectric conversion element can be increased without decreasing electric characteristics, such as an open circuit voltage.

In the photoelectric conversion element according to the aforementioned aspect, the light scattering layer may be formed by a metal having a fine structure. The photoelectric conversion layer may be formed by single crystalline silicon, polycrystalline silicon, or microcrystalline silicon. The transparent thin layer may be formed by a silicon-containing material.

A photoelectric conversion element in which the respective components described above are appropriately combined can also be encompassed within the scope of the invention for which protection is sought by this application.

ADVANTAGE OF THE INVENTION

According to the present invention, in a photoelectric conversion element in which a light scattering layer is provided on at least one surface of a photoelectric conversion layer, an effect of increasing current can be obtained, while suppressing a decrease in the performance of a solar cell.

BRIEF DESCRIPTION OF THE DRAWINGS

Fig. 1(A) is a schematic sectional view illustrating the configuration of a photoelectric conversion element according to an embodiment;
Fig. 1(B) is a plan view illustrating a pattern in which metal nano-particles are arrayed, when a semiconductor substrate is planarly viewed from the rear surface side thereof;
Figs. 2(A) to 2(D) are step sectional views illustrating a manufacturing method of a photoelectric conversion element according to an embodiment;
Figs. 3(A) and 3(B) are step sectional views illustrating a manufacturing method of a photoelectric conversion element according to an embodiment;
Fig. 4 is a graph in which, in the solar cell of each of Examples and Comparative Examples, the relationship between the thickness $d_{low}$ of a transparent thin layer and a relative current value is plotted; and
Fig. 5 is a graph in which the maximum thickness of the transparent thin layer at which an increase in the relative current value can be achieved, which has been obtained by a linear approximation, is plotted.

BEST MODE FOR CARRYING OUT THE INVENTION

Hereinafter, preferred embodiments of the present invention will de described with reference to the accompanying drawings. Like components illustrated in each drawing are denoted by like reference numerals, and duplicative descriptions thereof will be appropriately omitted.

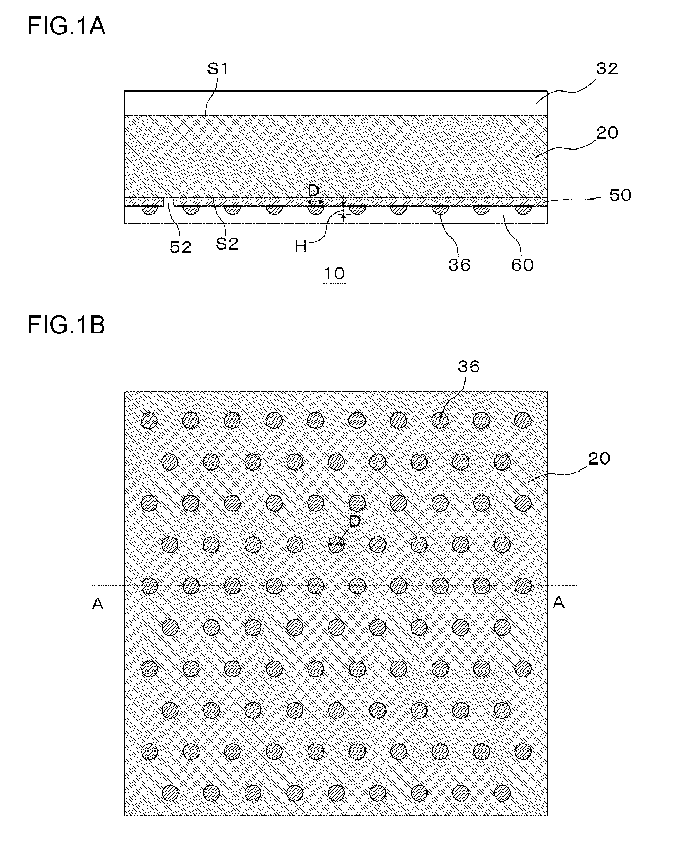

Fig. 1(A) is a schematic sectional view illustrating the configuration of a photoelectric conversion element 10 according to an embodiment. Fig. 1(B) is a plan view illustrating a pattern in which metal nano-particles that form a light scattering layer 36 are arrayed, when the photoelectric conversion is planarly viewed from the side opposite to a light-receiving surface. Fig. 1(A) is equivalent to a sectional view, taken along A-A Line in Fig. 1(B). In Fig. 1(B), the arrangement of both the metal nano-particles that form the light scattering layer 36 and a photoelectric conversion layer 20 is only illustrated, and other configurations are omitted. As illustrated in Fig. 1(A), the photoelectric conversion element 10 comprises the photoelectric conversion layer 20, an anti-reflection film 32, a transparent thin layer 50, the light scattering layer 36, and a transparent conductive film 60. In the present embodiment, the photoelectric conversion element 10 is a solar cell.

The photoelectric conversion layer 20 has a pn junction in which a p-type semiconductor and an n-type semiconductor are joined together, so that the light energy from the sun is converted into electrical energy by the photovoltaic effect of the pn junction. A direct current can be extracted outside the photoelectric conversion element 10 by attaching an electrode (not illustrated) to each of the n-type semiconductor and the p-type semiconductor. In the present embodiment, the electrode provided on the side opposite to the light-receiving surface is electrically connected to the photoelectric conversion layer 20 by being laminated on the later-described transparent thin layer 50. The photoelectric conversion layer 20 is a Si substrate made, for example, of single crystalline silicon, polycrystalline silicon, or microcrystalline silicon, and has a pn junction that is well known as a solar cell formed by a group IV semiconductor substrate.

As illustrated in Figs. 1(A) and 1(B), the anti-reflection film 32 is provided on a first major surface S1 of the photoelectric conversion layer 20 on the light-receiving surface side. The anti-reflection film 32 is not particularly limited in its form and material, as far as it has both transparency in the wavelength range of the light received by the photoelectric conversion element 10 and a function of preventing the reflection of the light received thereby. The anti-reflection film 32 is made, for example, of $SiO_2$, $SiN_x$, $TiO_2$, ITO, etc. The anti-reflection film 32 is arbitrarily provided, and an embodiment in which the anti-reflection film 32 is not provided in the photoelectric conversion element 10 is also encompassed by the present invention.

The light scattering layer 36 is provided in a two-dimensional arrangement via the later-described transparent thin layer 50, on the side opposite to the light receiving surface of the photoelectric conversion element 10. In the present embodiment, the light scattering layer 36 includes a plurality of metal nano-particles that are interspersed in a two-dimensional array on the transparent thin layer 50.

The material of the metal nano-particles that form the light scattering layer 36 is not particularly limited, as far as it is a metal material. However, it is desirable that the resonance wavelength of the Frohlich mode (see Bohren and Huffman, Absorption and Scattering of Light by Small Particles, Wiley, 1983) is close to the wavelength of the light whose reflection is prevented, and examples of the material include, for example, Au, Ag, Al, Cu, and alloys of these metals. In the present embodiment, the transparent conductive film 60 made of ITO, or the like, is laminated so as to cover the light scattering layer 36. The transparent conductive film 60 is injected into a penetration part 52 provided on the transparent thin layer 50 such that the transparent conductive film 60 and the photoelectric conversion layer 20 are electrically connected to each other via the penetration part 52.

When the photoelectric conversion layer 20 is planarly viewed, the number density per unit area of the metal nano-particles is preferably $5.0 \times 10^8$ pieces/$cm^2$ to $3.0 \times 10^9$ pieces/$cm^2$, more preferably $7.0 \times 10^8$ to $2.5 \times 10^9$ pieces /$cm^2$, and still more preferably $1.0 \times 10^9$ to $2.0 \times 10^9$ pieces/$cm^2$.

The shape of the metal nano-particle is not particularly limited, but examples thereof include, for example, a spherical shape, hemispherical shape, cylindrical shape, prismatic shape, rod shape, and disk shape, etc. When the photoelectric conversion layer 20 is planarly viewed, the diameter D of the metal nano-particles is, for example, 80 to 400 nm. The height H of the metal nano-particles, occurring when a major surface of the transparent thin layer 50, which is on the side opposite to the photoelectric conversion layer 20, is made to be a reference level, is, for example, 5 to 500 nm.

The transparent thin layer 50 is laminated on a second major surface S2 of the photoelectric conversion layer 20, and the aforementioned light scattering layer 36 is laminated on a major surface of the transparent thin layer 50, the major surface being on the side opposite to the photoelectric conversion layer 20. In other words, the transparent thin layer 50 is provided between the light scattering layer 36 and the photoelectric conversion layer 20. The transparent thin layer 50 is transparent for the light received by the photoelectric conversion element 10. That is, the band gap of the transparent thin layer 50 is larger than that of the photoelectric conversion layer 20. When an electrode is formed on the second major surface S2 side of the photoelectric conversion layer 20, it is desirable that the transparent thin layer 50 has conductivity, from the viewpoint of an improvement in power collection characteristics.

Examples of the material of the transparent thin layer 50 include, calcium fluoride, magnesium fluoride, barium fluoride, lithium fluoride, silicon carbide, sapphire, alumina, crystal, fluorine resin, $SnO_2$, FTO (fluorine doped tin oxide), ITO, ZnO, $SiO_2$, $TiO_2$, $ZrO_2$, $Mn_3O_4$, $Y_2O_3$, $WO_3$, $Nb_2O_5$, $La_2O_3$, $Ga_2O_3$, $Ag_2O$, CuO, a-Si:H, μc-Si:H, $SiO_x$:H, SiC, $SiN_x$, $AlO_x$:H, polyethylene terephthalate, polycarbonate, polymethyl methacrylate, polyethylene, polypropylene, ethylene-vinylacetate copolymer, polystyrene, polyimide, polyamide, polybutylene terephthalate, polyethylene naphthalate, polysulfone, polyether sulphone, polyether ether ketone, polyvinyl alcohol, polyvinyl chloride, polyvinylidene chloride, triacetyl cellulose, polyurethane, and cycloolefin polymer, etc.

In a form in which metal nano-particles are used as the light scattering layer 36, as in the present embodiment, if the metal-nano-particles contact the photoelectric conversion layer 20, there is the possibility that: a recombination reaction of carriers may be promoted on the metal-semiconductor interface between the metal nano-particles and the photoelectric conversion layer 20; or the photoelectric conversion efficiency of the photoelectric conversion element 10 may be decreased because the photoelectric conversion layer 20 is contaminated with the metal atoms that form the metal nano-particles being diffused into the photoelectric conversion layer 20. Accordingly, by interposing the transparent thin layer 50 between the second major surface of the photoelectric conversion layer 20 and the metal nano-particles that form the light scattering layer 36, as in the present embodiment, recombination of carriers, possibly occurring between the metal nano-particles and the photoelectric conversion layer 20, can be suppressed.

The thickness $d_{low}$ of the transparent thin layer 50 is represented by the following equation.

[Equation 2]

$$0 < d_{low} < \lambda_0 \left(\frac{n_{low}}{n_{abs}}\right)^2 \frac{1}{n_{abs}^2 - n_{low}^2}$$

wherein $\lambda_0$ represents an arbitrary wavelength of light in vacuum, the light being able to be absorbed by the photoelectric conversion layer; nabs represents a refractive index of the photoelectric conversion layer 20 at the wavelength; and $n_{low}$ represents a refractive index of the transparent thin layer 50 at the wavelength.

According to the photoelectric conversion element 10 of the aforementioned embodiment, the incident light that has not been absorbed by the photoelectric conversion element 10 is scattered and reflected by the light scattering layer 36 provided on the second major surface side of the photoelectric conversion element 10, and hence the optical path length for incident light in the photoelectric conversion layer 20 is increased, thereby allowing the incident light to be efficiently absorbed. Further, in the photoelectric conversion element 10 according to the embodiment, by interposing the aforementioned transparent thin layer 50 having a thickness of $d_{low}$ between the photoelectric conversion layer 20 and the light scattering layer 36, an effect of increasing current in the photoelectric conversion element 10 can be increased without decreasing electric characteristics, such as an open circuit voltage. In more detail, by making the thickness of the transparent thin layer 50 to be $d_{low}$, propagation of a near field induced by the light scattering layer 36 to the photoelectric conversion layer 20 is not hampered by the light scattering layer 36; and hence an effect of extending the optical path length by the light scattering layer 36 can be sufficiently obtained, which finally leads to an increase in the effect of increasing current in the photoelectric conversion element 10.

(Manufacturing Method of Photoelectric Conversion Element)

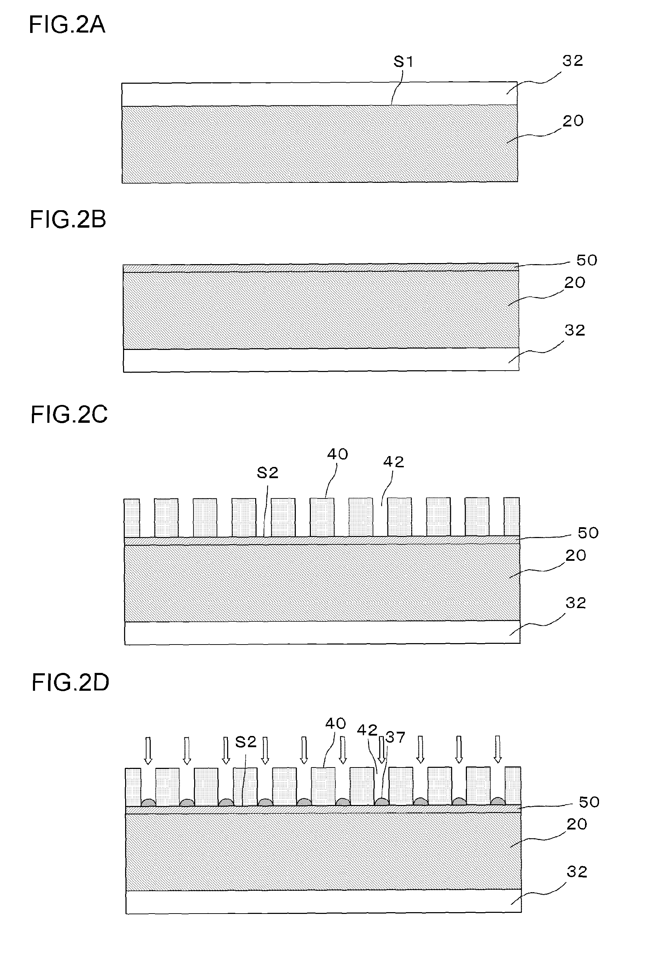

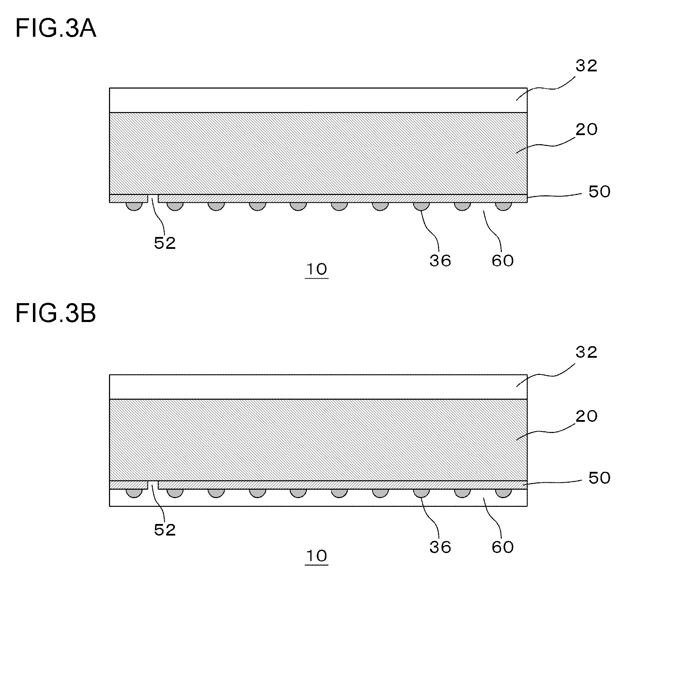

Figs. 2 (A) to 2 (D) and Figs. 3 (A) and 3 (B) are step sectional views illustrating a manufacturing method of the photoelectric conversion element according to an embodiment. The manufacturing method thereof will be described with reference to these views.

As illustrated in Fig. 2 (A), the anti-reflection film 32 having a thickness of 50 to 200 nm is first laminated on the first major surface S1 of the photoelectric conversion layer 20 that serves as the light receiving surface. Herein, the photoelectric conversion layer 20 includes a p-type single crystalline Si substrate, and a p-n junction is formed in advance by using a well-known thermal diffusion method, ion implantation method, vacuum film formation method, or the like. A lamination method of the anti-reflection film 32 is not particularly limited, but a method, in which a transparent material, such as $SiN_x$, ITO, or the like, is formed into the photoelectric conversion layer 20 by using, for example, a vacuum film formation method, such as PECVD method, sputtering method, or the like, can be cited.

Subsequently, the transparent thin layer 50 is formed on the second major surface S2 of the photoelectric conversion layer 20, the second major surface S2 being on the side opposite to the light receiving surface, as illustrated in Fig. 2 (B). The material and thickness of the transparent thin layer 50 are described above. A forming method of the transparent thin layer 50 is not particularly limited, but examples thereof include a PECVD method, sputtering method, vacuum deposition method, ALD method, PLD method, thermal oxidation method, and spin coating method, etc.

Subsequently, a mask 40 is formed on the transparent thin layer 50, as illustrated in Fig. 2(C). A plurality of openings 42 are provided in the mask 40 such that a metal nano-particles formation region is exposed on the transparent thin layer 50. The mask 40 can be formed by subjecting the surface of, for example, an aluminum substrate to an anode oxidation and then by forming through-holes in the anode-oxidized surface (porous aluminum film) of the aluminum substrate by using a phosphoric acid solution after the aluminum substrate, other than the anode-oxidized surface, is removed. Besides this method, the mask 40 can also be formed by a resist in which predetermined openings are patterned. By using the resist as the mask 40, the metal nano-particles can be arranged two-dimensionally.

Subsequently, either a metal, such as Ag, Al, Au, Cu, or the like, or an alloy including these metals is deposited, by a vacuum deposition method, toward the transparent thin layer 50 via the mask 40, as illustrated in Fig. 2(D). Metal particles pass through the openings 42 provided in the mask 40, and are selectively deposited on the transparent thin layer 50 in the openings 42. Thereby, the metal nano-particles 37 are formed in the openings and the plurality thereof are arranged two-dimensionally on the transparent thin layer 50. When the photoelectric conversion layer 20 is planarly viewed, the size of the metal nano-particles 37 is defined by the size of the opening 42 provided in the mask 40. When the mask 40 is formed by using a porous aluminum film, the size of the opening 42 becomes proportional to a voltage applied when the aluminum substrate is subjected to the anode oxidation. For example, when 120 V is applied to an aluminum substrate in a malonic acid electrolyte solution having a concentration of 0.3 mol/l, the diameter of the opening 42 becomes approximately 150 nm and the diameter of the metal nano-particles 37 also becomes the same. The height of the metal nano-particles 37, occurring when the second major surface of the photoelectric conversion layer 20 is made to be a reference level, can be controlled by changing the period of time of the vacuum deposition. When the period of time thereof is short, each of the metal nano-particles 37 has a hemispherical shape in which the spherical surface is oriented downward (the direction of being away from the second major surface thereof). When the period of time thereof is sufficiently long, each of the metal nano-particles 37 has a cylindrical shape, prismatic shape, or a filler shape. After the formation of the metal nano-particles 37 is completed, the mask 40 is removed.

Subsequently, the penetration part 52 is formed by partially removing the transparent thin layer 50 by using a well-known lithography method, as illustrated in Fig. 3 (A). The photoelectric conversion layer 20 is exposed in the penetrated part 52.

Subsequently, the transparent conductive film 60 made of ITO, or the like, is formed so as to cover the metal nano-particles 37, as illustrated in Fig. 3(B). By the aforementioned steps, the photoelectric conversion element 10 according to an embodiment can be easily formed, which finally leads to a reduction in the manufacturing cost of the photoelectric conversion element 10.

(Example 1)

<Production of Photoelectric Conversion Layer>

A pn junction was formed by diffusing phosphorus into a p-type silicon wafer having a thickness of 150 $\mu$m (resistivity: 0.5 to 5 $\Omega$cm), thereby allowing a photoelectric conversion layer to be produced. Phosphorus oxychloride was used for the diffusion of phosphorus, and doping was performed for 40 minutes after the silicon wafer was heated at 860°C for 20 minutes. The refractive index of single crystalline silicon that forms the photoelectric conversion layer is 3.57 for the light having a wavelength of 1000 nm, according to Handbook of Optical Constants of Solids (by Palik).

<Production of Anti-Reflection Film>

A layer having a thickness of 70 nm, the major component of which was SiN, was formed into a film, as a surface passivation layer (anti-reflection film), on one major surface of the photoelectric conversion layer.

<Production of Transparent Thin Layer>

An $AL_2O_3$ layer was formed, on the surface (rear surface) where the photoelectric conversion layer was exposed, into a film as a transparent thin film having a refractive index different from that of the photoelectric conversion layer by a PECVD method. The thickness of the transparent thin layer was evaluated by using a contact-type film thickness meter (Veeco Dektak3 ST). In addition, the refractive index of the transparent thin layer was determined by the fitting using: a reflectance spectrum measured with a spectrophotometer (Hitachi U4100); a thickness measured with the contact-type film thickness meter; and a refractive index calculated by a transfer matrix method. The thickness and refractive index of the transparent thin layer of Example 1 were measured to be 10 nm and 1.8, respectively. Herein, when the transparent thin layer is formed by a plurality of materials each having a refractive index different from the others, an average refractive index can be determined from the following equation.

[Equation 3]

$$n = \sum_i n_i \eta_i$$

wherein n represents an average refractive index; $n_i$ represents the refractive index of each component; and $\eta_i$ represents the volume fraction of each component.

<Production of Light Scattering Layer>

After the surface of the aluminum substrate was subjected to anode oxidation by 120 V in a malonic acid electrolyte solution having a concentration of 0.3 mol/l, the aluminum substrate, other than the oxidized surface (barrier layer), was removed. Many holes formed in the barrier layer were then formed into through-holes by using a phosphoric acid aqueous solution that has been diluted 20 times and the diameters thereof were further enlarged, thereby allowing an aluminum mask having an average hole diameter of 200 $\mu$m and a hole density of $1.8 \times 10^9$ holes/cm$^2$ to be obtained. A metal nano-particles array having a height of 100 nm and a pitch of 300 nm was formed by vapor depositing Ag on the transparent thin layer through this aluminum mask. It was confirmed by using a scanning electron microscope (SEM) that the diameter and density of the obtained metal nano-particles were respectively the same as those of the through-holes formed in the aluminum mask that was used in the vapor deposition.

<Production of ITO Layer>

The photoelectric conversion layer was partially exposed by selectively etching the transparent thin layer. The metal nano-particles array was covered by forming, on the light scattering layer, an ITO film having a thickness of 200 nm, and a transparent conductive film electrically connected to the photoelectric conversion was formed.

<Production of Electrode>

A fine line electrode was formed on SiN that formed the surface passivation layer by using a silver paste, and it was electrically connected to the photoelectric conversion layer by executing a fire-through process of firing. Also, a full- area electrode made of Ag/Al was formed on a major surface of the ITO, the major surface being on the side opposite to the photoelectric conversion layer.

A photoelectric conversion element (solar cell) of Example 1 was produced by the aforementioned steps.

For comparison, a solar cell similar to that of Example 1 (hereinafter, referred to as Reference Example) was produced to measure the open circuit voltage thereof. The open circuit voltage of the solar cell of Reference Example was 590 mV. On the other hand, that of the solar cell of Example 1 was 589 mV. That is, it has been confirmed that the open circuit voltage of the solar cell of Example 1 was equivalent to that in Reference Example in which a light scattering layer is not formed.

(Comparative Example 1)

A solar cell of Comparative Example 1 has a structure similar to that in Example 1, except that a light scattering layer similar to that in Example 1 is directly formed on the rear surface (surface on the side opposite to the light receiving surface) of the photoelectric conversion layer and an $Al_2O_3$ layer (refractive index: 1.8, thickness: 10 nm) is formed on the light scattering layer by a PECVD method. The open circuit voltage of the solar cell of Comparative Example 1 was 535 mV, which was lower than that in Reference Example.

(Comparative Example 2)

A solar cell of Comparative Example 2 has a structure similar to that of the solar cell of Example 1, except that the thickness of the transparent thin layer ($Al_2O_3$ layer) is made to be 25 nm. The open circuit voltage of the solar cell of Comparative Example 2 was 592 mV, which was equivalent to that in Reference Example.

(Comparative Example 3)

A solar cell of Comparative Example 3 has a structure similar to that of the solar cell of Example 1, except that the thickness of the transparent thin layer ($Al_2O_3$ layer) is made to be 40 nm. The open circuit voltage of the solar cell of Comparative Example 3 was 591 mV, which was equivalent to that in Reference Example.

(Comparative Example 4)

A solar cell of Comparative Example 4 has a structure similar to that of the solar cell of the Example 1, except that the thickness of the transparent thin layer ($Al_2O_3$ layer) is made to be 100 nm. The open circuit voltage of the solar cell of Comparative Example 2 was 592 mV, which was equivalent to that in Reference Example.

(Example 2)

A solar cell of Example 2 has a structure similar to that of the solar cell of Example 1, except that a silicon dioxide film (refractive index: 1.5, thickness : 6 nm) is formed as a transparent thin layer by a thermal oxidation method. The open circuit voltage of the solar cell of Example 2 was 585 mV, which was equivalent to that in Reference Example.

(Comparative Example 5)

A solar cell of Comparative Example 5 has a structure similar to that of the solar cell of Example 1, except that a silicon dioxide film (refractive index: 1.5, thickness: 16 nm) is formed as a transparent thin layer by a thermal oxidation method. The open circuit voltage of the solar cell of Comparative Example 5 was 586 mV, which was equivalent to that in Reference Example.

(Comparative Example 6)

A solar cell of Comparative Example 6 has a structure similar to that of the solar cell of Example 1, except that a silicon dioxide film (refractive index; 1.5, thickness: 20 nm) is formed as a transparent thin layer by a thermal oxidation method. The open circuit voltage of the solar cell of Comparative Example 6 was 588 mV, which was equivalent to that in Reference Example.

(Comparative Example 7)

A solar cell of Comparative Example 7 has a structure similar to that of the solar cell of Example 1, except that a silicon dioxide film (refractive index: 1.5, thickness: 50 nm) is formed as a transparent thin layer by a thermal oxidation method. The open circuit voltage of the solar cell of Comparative Example 7 was 587 mV, which was equivalent to that in Reference Example.

(Example 3)

A solar cell of Example 3 has a structure similar to that of the solar cell of Example 1, except that a film layer whose major component is SiN (refractive index: 2.2, thickness: 40 nm) is formed as a transparent thin layer by a PECVD method. The open circuit voltage of the solar cell of Example 3 was 620 mV, which was equivalent to that in Reference Example.

(Example 4)

A solar cell of Example 4 has a structure similar to that of the solar cell of Example 1, except that a film layer whose major component is SiN (refractive index: 2.2, thickness: 40 nm) is formed as a transparent thin layer by a PECVD method. The open circuit voltage of the solar cell of Example 4 was 621 mV, which was equivalent to that in Reference Example.

(Comparative Example 8)

A solar cell of Comparative Example 8 has a structure similar to that of the solar cell of Example 1, except that a film layer whose major component is SiN (refractive index: 2.2, thickness: 63 nm) is formed as a transparent thin layer by a PECVD method. The open circuit voltage of the solar cell of Comparative Example 8 was 623 mV, which was equivalent to that in Reference Example.

(Comparative Example 9)

A solar cell of Comparative Example 9 has a structure similar to that of the solar cell of Example 1, except that a film layer whose major component is SiN (refractive index: 2.2, thickness: 80 nm) is formed as a transparent thin layer by a PECVD method. The open circuit voltage of the solar cell of Comparative Example 9 was 623 mV, which was equivalent to that in Reference Example.

(Example 5)

A solar cell of Example 5 has a structure similar to that of the solar cell of Example 1, except that a film layer whose major component is SiN (refractive index: 2.5, thickness: 10 nm) is formed as a transparent thin layer by a PECVD method. The open circuit voltage of the solar cell of Example 5 was 631 mV, which was equivalent to that in Reference Example.

(Example 6)

A solar cell of Example 6 has a structure similar to that of the solar cell of Example 1, except that a film layer whose major component is SiN (refractive index: 2.5, thickness: 50 nm) is formed as a transparent thin layer by a PECVD method. The open circuit voltage of the solar cell of Example 6 was 634 mV, which was equivalent to that in Reference Example.

(Comparative Example 10)

A solar cell of Comparative Example 10 has a structure similar to that of the solar cell of Example 1, except that a film layer whose major component is SiN (refractive index: 2.5, thickness: 100 nm) is formed as a transparent thin layer by a PECVD method. The open circuit voltage of the solar cell of Comparative Example 10 was 636 mV, which was equivalent to that in Reference Example.

(Comparative Example 11)

A solar cell of Comparative Example 11 has a structure similar to that of the solar cell of Example 1, except that a film layer whose major component is SiN (refractive index: 2.5, thickness: 125 nm) is formed as a transparent thin layer by a PECVD method. The open circuit voltage of the solar cell of Comparative Example 11 was 633 mV, which was equivalent to that in Reference Example.

(Example 7)

A solar cell of Example 7 has a structure similar to that of the solar cell of Example 1, except that a film layer whose major component is SiN (refractive index: 2.8, thickness: 40 nm) is formed as a transparent thin layer by a PECVD method. The open circuit voltage of the solar cell of Example 7 was 632 mV, which was equivalent to that in Reference Example.

(Example 8)

A solar cell of Example 8 has a structure similar to that of the solar cell of Example 1, except that a film layer whose major component is SiN (refractive index: 2.8, thickness: 100 nm) is formed as a transparent thin layer by a PECVD method. The open circuit voltage of the solar cell of Example 8 was 631 mV, which was equivalent to that in Reference Example.

(Example 9)

A solar cell of Example 9 has a structure similar to that of the solar cell of Example 1, except that a film layer whose major component is SiN (refractive index: 2.8, thickness: 125 nm) is formed as a transparent thin layer by a PECVD method. The open circuit voltage of the solar cell of Example 9 was 634 mV, which was equivalent to that in Reference Example.

(Comparative Example 12)

A solar cell of Comparative Example 12 has a structure similar to that of the solar cell of Example 1, except that a film layer whose major component is SiN (refractive index: 2.8, thickness: 158 nm) is formed as a transparent thin layer by a PECVD method. The open circuit voltage of the solar cell of Comparative Example 12 was 633 mV, which was equivalent to that in Reference Example.

<Measurement of Quantum Efficiency>

The spectral sensitivity of the solar cell of each of Examples and Comparative Examples was measured. The measurement was performed in the following way in which: monochromatic light having a wavelength of 300 to 1200 nm that had been dispersed by a monochromator was radiated onto a solar cell in the AC mode; the number of radiated photons and a photocurrent value, at each wavelength, were measured by a two-lamp type spectral sensitivity measuring device provided with a xenon lamp and a halogen lamp; and a quantum yield was calculated from the above two measured values. As a reference specimen, a solar cell was produced in a way similar to that in Example 1, except that the metal nano-particles were not formed, and the spectral sensitivity thereof was measured. By using this result as a reference, a relative quantum yield in the solar cell of each of Examples and Comparative Examples, with respect to each of the reference specimens, was calculated to compare a degree in which a short-circuit current value is improved. A relative current value in each of Examples and Comparative Examples is shown in Table 1. Herein, the relative current value means a relative value, when the short-circuit current value in the solar cell of Reference Example, in which a light scattering layer is not included, is made to be 1.

[Table 1]

| | EXAMPLE 1 | EXAMPLE 2 | EXAMPLE 3 | EXAMPLE 4 | EXAMPLE 5 | EXAMPLE 6 | EXAMPLE 7 | EXAMPLE 8 | EXAMPLE 9 |
|---|---|---|---|---|---|---|---|---|---|
| RELATIVE CURRENT VALUE | 1.008 | 1.008 | 1.010 | 1.002 | 1.009 | 1.004 | 1.008 | 1.002 | 1.000 |

| | COMPARATIVE EXAMPLE 1 | COMPARATIVE EXAMPLE 2 | COMPARATIVE EXAMPLE 3 | COMPARATIVE EXAMPLE 4 | COMPARATIVE EXAMPLE 5 | COMPARATIVE EXAMPLE 6 | COMPARATIVE EXAMPLE 7 | COMPARATIVE EXAMPLE 8 | COMPARATIVE EXAMPLE 9 |
|---|---|---|---|---|---|---|---|---|---|
| RELATIVE CURRENT VALUE | 1.009 | 1.001 | 0.996 | 0.995 | 0.996 | 0.997 | 0.989 | 0.999 | 0.998 |

| | COMPARATIVE EXAMPLE 10 | COMPARATIVE EXAMPLE 11 | COMPARATIVE EXAMPLE 12 |
|---|---|---|---|
| RELATIVE CURRENT VALUE | 0.999 | 0.998 | 0.998 |

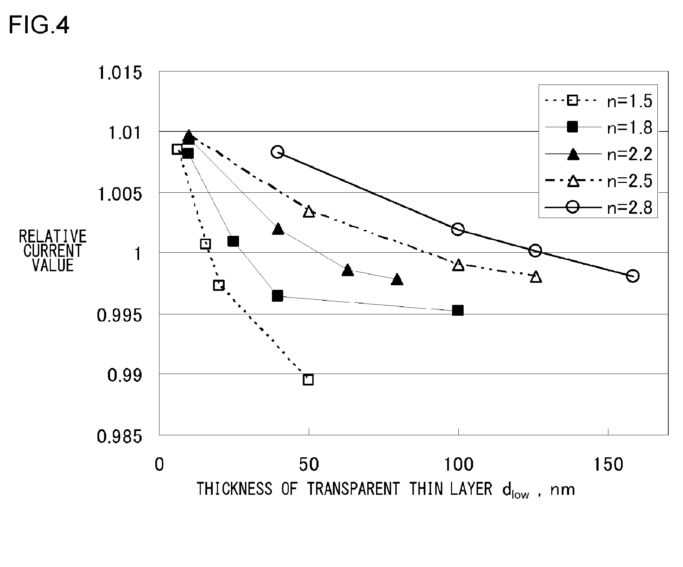

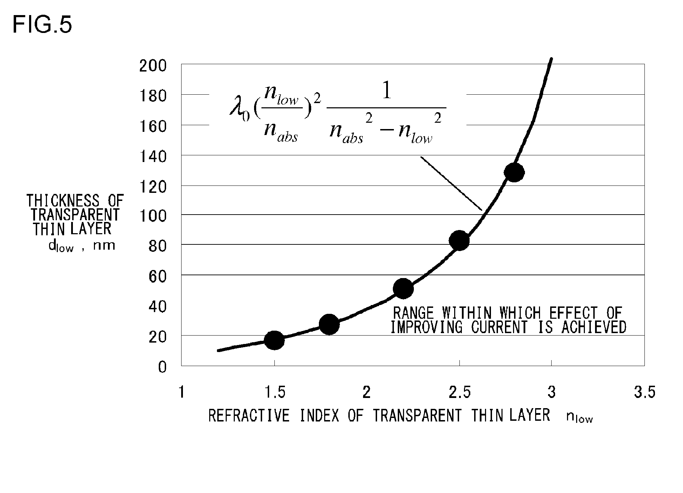

Fig. 4 is a graph in which, in the solar cell of each of Examples and Comparative Examples, the relationship between the thickness $d_{low}$ of the transparent thin layer and a relative current value is plotted. Fig. 5 is a graph in which the maximum thickness of the transparent thin layer at which an increase in the relative current value can be achieved, which has been obtained by a linear approximation, is plotted. The range of the thickness of the transparent thin layer, within which an effect of improving a current is achieved, can be represented by the equation illustrated in Fig. 5. However, $\lambda_0$ = 1000 nm and $n_{abs}$ = 3.57, taking into consideration that the photoelectric conversion element of each Example is a crystalline silicon solar cell.

The present invention should not be limited to the aforementioned embodiments, and various modifications, such as design modifications, can be made with respect to the above embodiments based on the knowledge of those skilled in the art, and an embodiment with such a modification can be encompassed within the scope of the present invention.

For example, in the aforementioned embodiments, a p-n junction is formed in the photoelectric conversion layer 20; however, the photoelectric conversion layer 20 is only required to have a structure in which photoelectric conversion can be achieved, and a p-i-n junction may be formed in the photoelectric conversion layer 20.

DESCRIPTION OF REFERENCE NUMERALS

10   PHOTOELECTRIC CONVERSION ELEMENT
20   PHOTOELECTRIC CONVERSION LAYER
32   ANTI-REFLECTION FILM
36   LIGHT SCATTERING LAYER
40   MASK
50   TRANSPARENT THIN LAYER

INDUSTRIAL APPLICABILITY

The present invention can be applied to a photoelectric conversion element that converts light energy into electrical energy by photoelectric conversion.

**Claims**

1.   A photoelectric conversion element comprising:

a photoelectric conversion layer; a transparent thin layer that is laminated on one major surface of the photoelectric conversion layer and that has a refractive index different from that of the photoelectric conversion layer; and a light scattering layer laminated on a major surface of the transparent thin layer, the major surface being on the side opposite to the photoelectric conversion layer, wherein a thickness $d_{low}$ of the transparent thin layer is represented by the following equation.

[Equation 1]

$$0 < d_{low} < \lambda_0 (\frac{n_{low}}{n_{abs}})^2 \frac{1}{n_{abs}^2 - n_{low}^2}$$

wherein $\lambda_0$ represents an arbitrary wavelength of light in vacuum, the light being able to be absorbed by the photoelectric conversion layer; nabs represents a refractive index of the photoelectric conversion layer at the wavelength; and $n_{low}$ represents a refractive index of the transparent thin layer at the wavelength.

2. The photoelectric conversion element according to claim 1, wherein
the light scattering layer is formed by a metal having a fine structure.

3. The photoelectric conversion element according to claim 1 or claim 2, wherein
the photoelectric conversion layer is formed by single crystalline silicon, polycrystalline silicon, or microcrystalline silicon.

4. The photoelectric conversion element according to any one of claims 1 to 3, wherein
the transparent thin layer is formed by a silicon-containing material.

FIG.1A

FIG.1B

FIG.2A

FIG.2B

FIG.2C

FIG.2D

FIG.3A

10

FIG.3B

10

FIG.4

FIG.5

$$\lambda_0 \left(\frac{n_{low}}{n_{abs}}\right)^2 \frac{1}{n_{abs}^2 - n_{low}^2}$$

THICKNESS OF
TRANSPARENT
THIN LAYER
$d_{low}$ , nm

RANGE WITHIN WHICH EFFECT OF
IMPROVING CURRENT IS ACHIEVED

REFRACTIVE INDEX OF TRANSPARENT THIN LAYER $n_{low}$

**EP 2 717 323 A1**

### INTERNATIONAL SEARCH REPORT

| International application No. |
|---|
| PCT/JP2012/003008 |

**A. CLASSIFICATION OF SUBJECT MATTER**
*H01L31/04(2006.01)i*

According to International Patent Classification (IPC) or to both national classification and IPC

**B. FIELDS SEARCHED**

Minimum documentation searched (classification system followed by classification symbols)
H01L31/04

Documentation searched other than minimum documentation to the extent that such documents are included in the fields searched
Jitsuyo Shinan Koho          1922-1996   Jitsuyo Shinan Toroku Koho   1996-2012
Kokai Jitsuyo Shinan Koho    1971-2012   Toroku Jitsuyo Shinan Koho   1994-2012

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 9-69642 A (Semiconductor Energy Laboratory Co., Ltd.), 11 March 1997 (11.03.1997), paragraphs [0040] to [0050]; fig. 2 & US 5711824 A          & US 5891264 A | 1-4 |
| A | JP 4-334069 A (Canon Inc.), 20 November 1992 (20.11.1992), entire text; all drawings & US 5282902 A | 1-4 |
| A | JP 2001-127313 A (Sony Corp.), 11 May 2001 (11.05.2001), entire text; all drawings (Family: none) | 1-4 |

☐ Further documents are listed in the continuation of Box C.     ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 31 May, 2012 (31.05.12) | 12 June, 2012 (12.06.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000294818 A
- JP 2001127313 A
- JP 2009533875 A

**Non-patent literature cited in the description**

- **BECK et al.** *Journal of Applied Physics,* 2009, vol. 105, 114310
- **MOKKAPATI et al.** *Applied Physics Letters,* 2009, vol. 95, 053115
- **BOHREN ; HUFFMAN.** Absorption and Scattering of Light by Small Particles. Wiley, 1983